# EUROPEAN PATENT SPECIFICATION

(11) **EP 1 864 297 B1**
(45) Date of publication and mention of the grant of the patent: **13.08.2008**
(21) Application number: 06727687.3
(22) Date of filing: 20.03.2006
(51) Int. Cl.: G11C 19/18, G11C 19/28, G09G 3/36

(54) **SHIFT REGISTER CIRCUIT USING TWO BOOTSTRAP CAPACITORS**
SCHIEBEREGISTERSCHALTUNG MIT ZWEI BOOTSTRAP-KONDENSATOREN
CIRCUIT À REGISTRE À DÉCALAGE

(30) Priority: 22.03.2005 EP 05102310
(43) Date of publication of application: 12.12.2007
(73) Proprietor: Koninklijke Philips Electronics N.V., 5621 BA Eindhoven (NL)
(72) Inventor: DEANE, Steven C., c/o Philips IP & Standards, Redhill Surrey RH1 5HA (GB)
(74) Representative: Damen, Daniel Martijn
(86) International application number: PCT/IB2006/050854
(87) International publication number: WO 2006/100636

(56) References cited:
- EP-A- 1 156 491
- WO-A-98/26423
- US-A- 6 064 713
- US-A1- 2003 052 848

## Description

This invention relates to shift register circuits, in particular for providing the row voltages to the display pixels of an active matrix display device.

Active matrix display devices comprise an array of pixels arranged in rows and columns, and each comprising at least one thin film drive transistor and a display element, for example a liquid crystal cell. Each row of pixels shares a row conductor, which connects to the gates of the thin film transistors of the pixels in the row. Each column of pixels shares a column conductor, to which pixel drive signals are provided. The signal on the row conductor determines whether the transistor is turned on or off, and when the transistor is turned on (by a high voltage pulse on the row conductor) a signal from the column conductor is allowed to pass on to an area of liquid crystal material, thereby altering the light transmission characteristics of the material.

The frame (field) period for active matrix display devices requires a row of pixels to be addressed in a short period of time, and this in turn imposes a requirement on the current driving capabilities of the transistor in order to charge or discharge the liquid crystal material to the desired voltage level. In order to meet these current requirements, the gate voltage supplied to the thin film transistor needs to fluctuate with significant voltage swings. In the case of amorphous silicon drive transistors, this voltage swing may be approximately 30 volts.

The requirement for large voltage swings in the row conductors requires the row driver circuitry to be implemented using high voltage components.

There has been much interest in integrating the components of the row driver circuit onto the same substrate as the substrate of the array of display pixels. One possibility is to use polycrystalline silicon for the pixel transistors, as this technology is more readily suitable for the high voltage circuit elements of the row driver circuitry. The cost advantages of producing the display array using amorphous silicon technology are then lost.

There is therefore an interest in providing driver circuits which can be implemented using amorphous silicon technology. The low mobility of amorphous silicon transistors, as well as the stress-induced change in threshold voltage, present serious difficulties in implementing driver circuits using amorphous silicon technology.

The row driver circuit is conventionally implemented as a shift register circuit, which operates to output a row voltage pulse on each row conductor in turn.

Essentially, each stage of the shift register circuit comprises an output transistor connected between a clocked high power line and the row conductor, and the drive transistor is turned on to couple the row conductor to the clocked high power line to generate a row address pulse. In order to ensure that the voltage on the row conductor reaches the power line voltage (despite the series-connected drive transistor), it is known to take advantage of a bootstrapping effect, using a stray capacitance of the output transistor. This is discussed in US 6 052 426, against which the independent claims are delimited.

A problem with the use of the parasitic capacitances of the drive transistor in this way is that there are other stray effects, and these are also discussed in US 6 052 426. One solution to this is to cancel the effect of the stray capacitance by introducing a first additional capacitor, and to introduce a second additional capacitor dedicated to the bootstrapping operation.

Shift register circuits using additional bootstrapping capacitors in this way are disclosed in US 6 052 426 and in US 6 064 713. In these circuits, the gate of the output transistor is charged by the row pulse of the preceding row, through an input transistor. As a result, the maximum gate voltage which can be applied to the output transistor is dependent on the threshold voltage of the input transistor. Particularly when implementing the shift register circuit using amorphous silicon technology, this can become a limiting factor in the performance of the circuit. This is particularly a problem at low temperatures, as the TFT mobility is then at its lowest, and the threshold voltage is at its highest.

W098/26423 discloses a bi-directional shift register including a source of a plurality of phase shifted clock signals having a first phase relationship there between, when a first direction of shifting is selected, and having a second phase relationship there between, when an opposite direction of shifting is selected. Such a bi-directional shift register comprises a plurality of cascaded stages. A given stage of the cascaded stages includes a first output transistor for generating an output pulse at an output of the given stage, when, during a corresponding clock signal with the given stage the transistor is enabled. D1 does not disclose a compensation capacitor for compensating the effects of a parasitic capacitance of the drive transistor. W098/26423 further does not disclose an input stage coupled to the output of the stage two or more stages before the stage comprising a second bootstrap capacitor.

US2003/0052848 discloses a shift register for driving a MOS image sensor or LCD. A positive side terminal of a first bootstrap capacitor is connected to a gate of a charge transistor of a subsequent stage. Consequently said gate of said charge transistor always is supplied with a high voltage of the positive side terminal of the bootstrap capacitor of its preceding stage and therefore a second bootstrap capacitor of the subsequent stage can be reliably charged up to a power supply voltage.

According to the invention, there is provided a shift register circuit comprising a plurality of stages, each stage comprising:
a first input connected to the output of a preceding stage;
a drive transistor for coupling a first clocked power line voltage to the output of the stage;
a compensation capacitor for compensating for the effects of a parasitic capacitance of the drive transistor;
a first bootstrap capacitor connected between the gate of the drive transistor and the output of the stage; and
an input transistor for charging the first bootstrap capacitor and controlled by the first input,
wherein each stage further comprises an input section coupled to the output of the stage two or more stages before the stage, and wherein the input section comprises a second bootstrap capacitor connected between the gate of the input transistor and the first input.

This circuit arrangement uses two bootstrapping capacitors. One is to ensure the full power supply line voltage can be coupled to the output, and the other is for ensuring that the full row voltage from the preceding stage is coupled through the input transistor to the drive transistor during the gate charging step. The circuit has two precharge cycles of operation - a first cycle when the input transistor gate is precharged, and a second cycle when the drive transistor gate is precharged. This makes the circuit less sensitive to threshold voltage levels or variations, and enables implementation using amorphous silicon technology.

Each stage preferably further comprises a second input connected to the output of the next stage, connected to the gate of a reset transistor which is connected between the gate of the drive transistor and a low power line. The circuit thus has two precharge cycles, one output cycle, and a reset cycle.

The compensation capacitor of each stage is preferably connected between the gate of the drive transistor and a second clocked power line voltage which is clocked complementarily with the first power line voltage. This operates to cancel the effects of parasitic capacitances of the drive transistor.

In one embodiment, the input section comprises circuit elements for storing a transistor threshold voltage on the second bootstrap capacitor.

For example, the input section may further comprise:
a second input transistor which supplies the output of the stage two or more stages before the stage to the gate of the first input transistor; and
a decay transistor connected in parallel with the second bootstrap capacitor for decaying the voltage on the second bootstrap capacitor until the threshold voltage of the decay transistor is reached.

The decay transistor preferably has its gate connected to the gate of the first input transistor, so that they are subject to the same voltage stress, and may also have the same dimensions as the first input transistor. The decay transistor is thus used as a model of the input transistor, and the decay transistor threshold voltage is used to represent the input transistor threshold voltage.

The input section may further comprise a reset transistor having its gate connected to the output of the stage, for discharging the second bootstrap capacitor.

In another embodiment, the input section further comprises a second input transistor, which supplies the output of the stage two or more stages before the stage to the gate of the first input transistor, and this can provide a higher voltage to the second bootstrap capacitor.

The first input transistor may then be connected between an input line and the gate of the drive transistor, and the input line is high when output of the stage before is high, and is high at least immediately after the output of the stage before has a transition from high to low.

The input section may further comprise an input section reset transistor which is connected between the gate of the first input transistor and a low power line.

The shift register circuit of the invention is particularly suitable for use in the row driver circuit of an active matrix display device, for example an active matrix liquid crystal display device.

The invention also provides a method of generating multiple stage shift register circuit outputs, comprising, for each stage of the shift register circuit:
using the output of the stage two or more stages before the stage to charge the gate of an input transistor, and storing the gate-source voltage on a second bootstrap capacitor;
using the output of the stage one or more stage before the stage to charge the gate of a drive transistor through the input transistor and to charge a first bootstrap capacitor storing the gate-source voltage of the drive transistor; and
coupling a first clocked power supply line voltage to the output of the stage through the drive transistor.

This provides the two-stage precharge operation explained above.

Again, the first bootstrap capacitor can be reset using the output of the next stage and the second bootstrap capacitor can be reset using the output of the stage.

An example of the invention will now be described in detail with reference to the accompanying drawings, in which:
Figure 1 shows a known shift register circuit;
Figure 2 shows a first example of shift register circuit of the invention;
Figure 3 shows a variation to the circuit of Figure 2;
Figure 4 shows the timing of operation of the circuit of Figure 2;
Figure 5 shows a second example of shift register circuit of the invention;
Figure 6 shows a variation to the circuit of Figure 5;
Figure 7 shows the timing of operation of the circuit of Figure 5;
Figure 8 shows a modification to the shift register circuit to simplify the external timing signals required to operate the circuit;
Figure 9 shows one example of a known pixel configuration for an active matrix liquid crystal display; and
Figure 10 shows a display device including row and column driver circuitry, in which the circuit of the invention can be used.

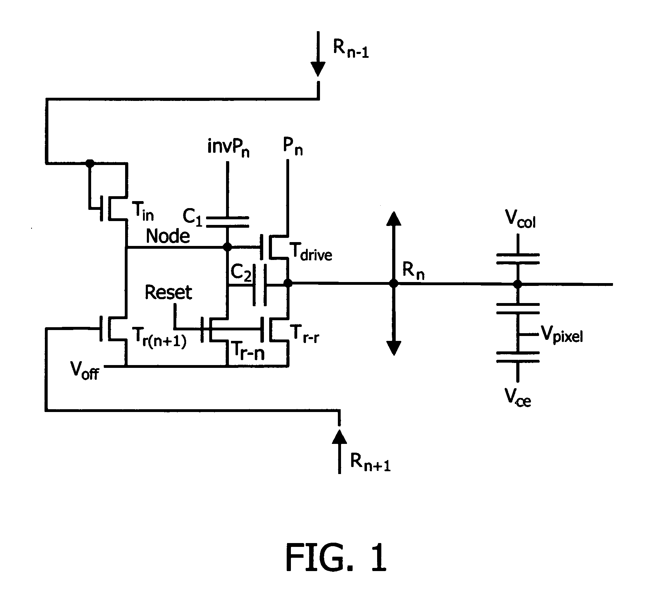

Figure 1 shows a known high impedance gate driver circuit suitable for use in amorphous silicon active matrix liquid crystal displays (AMLCDs). The circuit shown is a single stage of a multiple stage shift register, with each stage being used to supply a row voltage pulse to one row of pixels. A similar circuit has been described in US 6 052 426.

The circuit comprises an output drive transistor T_{drive} coupled between a clocked power line Pₙ and the row conductor Rₙ which is controlled by the stage. The clocked power line (and the complementary signal invPₙ) is a two phase signal, and the cycles of the clocked power line determine the timing of the sequential operation of the shift register stages.

The row pulse on the previous row Rₙ₋₁ is used to charge the output transistor gate through a diode-connected input transistor Tᵢₙ.

A first capacitor C₁ is connected between the output transistor gate and the control line which carries the complementary signal to the clocked power line Pₙ and the purpose of the capacitor C₁ is to offset the effects of internal parasitic capacitances of the output transistor.

An additional bootstrapping capacitor C₂ is provided between the gate of the output transistor and the row conductor (i.e. the output of the stage).

The stage is also controlled by the row pulse on the next row Rₙ₊₁, which is used to turn off the stage by pulling down the gate voltage of the output transistor. The row pulse on the next row Rₙ₊₁ is provided to the gate of the output transistor through an input transistor Tᵣ₍ₙ₊₁₎ associated with the next row conductor signal.

The circuit also has two reset transistors Tᵣ₋ₙ and Tᵣ₋ᵣ which are used when initially powering the circuit.

In operation, the input transistor Tᵢₙ charges the output transistor gate during the previous row pulse. During this previous row pulse, the power line Pₙ is low and the inverse power line invPₙ is high. The output transistor is turned on by this previous row pulse, but as the power line Pₙ is low, the output of the stage remains low.

During this charging stage, the bootstrapping capacitor C₂ is charged to the row voltage pulse (less the threshold voltage of the input transistor Tᵢₙ).

During the next clock cycle, the clock signal Pₙ is high, and this increase in voltage pulls up the output voltage on the row conductor Rₙ through the output transistor. The effect of the bootstrapping capacitor C₂ is to increase the gate voltage to ensure that the full voltage level of the clocked signal Pₙ is passed to the row conductor Rₙ. The transistor Tᵣ₍ₙ₊₁₎ subsequently resets the output transistor gate voltage node during the next row pulse.

In the idle state, the coupling of the inverse power line invPₙ through the first additional capacitor C₁ is designed to prevent the output transistor gate from turning on when the output transistor T_{drive} receives a pulse from Pₙ.

The operation of the circuit as described above will be known to those skilled in the art.

As mentioned above, one limitation of the operation of the circuit of Figure 1 is that the charging of the gate of the output transistor during the timing of the previous row pulse is dependent on the threshold voltage of the input transistor Tᵢₙ. For amorphous silicon transistors, this threshold voltage may be significant, and furthermore may vary significantly with temperature and over time.

The invention provides an additional input section which is coupled to the output of the stage two stages before the stage. This input section comprises a second bootstrap capacitor connected between the gate of the input transistor and the first input, and operates to cancel the effects of the threshold voltage of the input transistor in the charging of the drive transistor gate.

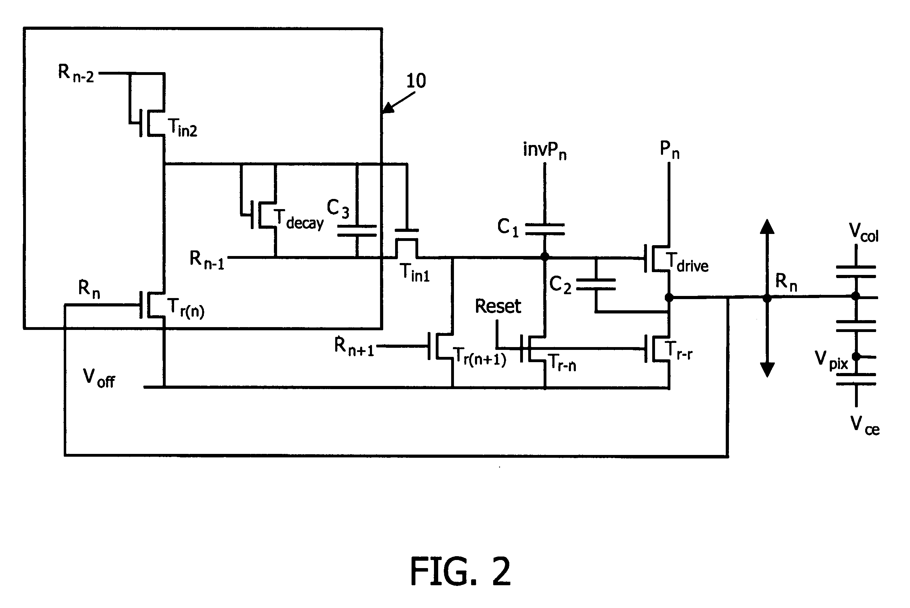

Figure 2 shows one stage of the shift register circuit of the invention.

The circuit includes a precharge circuit 10 which is used to sample a TFT threshold voltage onto a second bootstrap capacitor C₃. This is then used to bootstrap the input TFT Tᵢₙ₁, resulting in good charging of the gate of drive transistor gate voltage regardless of the threshold voltage of the input transistor. The row circuit then resets the charge on C₃, so that the input TFT Tᵢₙ₁ does not drift. The other parts of the circuit of Figure 2 are the same as in Figure 1, and a description of these components will not be repeated.

The precharge circuit 10 has an input connected to the output Rₙ₋₂ of the stage two before the stage shown. This output Rₙ₋₂ is coupled through a second input transistor Tᵢₙ₂ to the gate of the first input transistor Tᵢₙ₁.

The second bootstrap capacitor C₃ is connected between the gate of the first input transistor Tᵢₙ₁ and the output of the preceding stage Rₙ₋₁.

A decay transistor T_{decay} is connected in parallel with the second bootstrap capacitor C₃ and is diode-connected. The gate of the decay transistor is connected to the gate of the first input transistor Tᵢₙ₁ so that they experience the same voltage stress. The decay transistor preferably also has substantially the same dimensions as the first input transistor Tᵢₙ₁.

The precharge section 10 has a reset transistor Tr(n) having its gate connected to the output of the stage Rₙ, for discharging the second bootstrap capacitor C₃.

In operation, the row pulse for the row Rₙ₋₂ two behind the current row is used to charge the gate of the first input transistor Tᵢₙ₁ and the second bootstrap capacitor C₃ via the second input transistor Tᵢₙ₂. This charging is limited by the decay of the charge through the decay transistor T_{decay}.

When row n-2 goes low, the decay transistor T_{decay} causes the voltage across the second bootstrap capacitor C₃ to decay to approximately the TFT threshold voltage. The decay transistor T_{decay} and the first input transistor Tᵢₙ₁ experience the same gate biases at all times, so even in the event of any threshold voltage drift they will exhibit the same threshold voltage.

When row n-1 pulses high, the gate of the first input transistor Tᵢₙ₁ is bootstrapped by the second bootstrap capacitor C₃, resulting in good charging of the gate of the drive transistor T_{drive}.

When row n-1 goes low, the charge is not removed via Tᵢₙ₁ as it is near threshold. Instead, as soon as row n goes high, the discharge transistor Tᵣ₍ₙ₎ discharges the voltage across the second bootstrap capacitor C₃, turning the first input transistor Tᵢₙ₁ completely off.

The circuit operation then proceeds as in the known circuit of Figure 1.

The reset transistor Tᵣ₍ₙ₎ can be placed with its lower side connected to the low voltage line V_{off} (as shown), or it can be connected to the preceding row n-1.

The circuit of Figure 2 benefits from a low number of control lines. One disadvantage is that currents required to charge the capacitances in the circuit are drawn from the row outputs from other stages, and this limits performance.

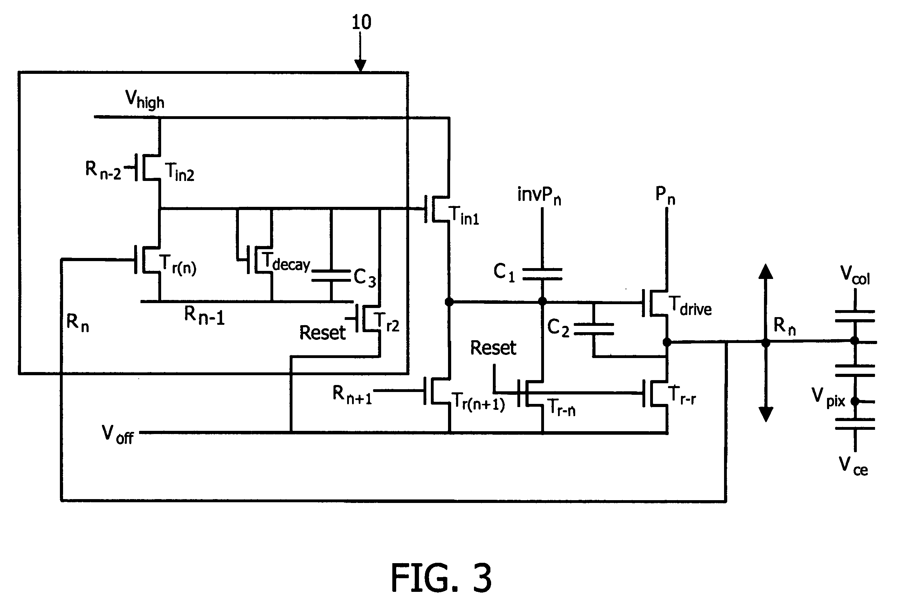

A modification to the circuit of Figure 2 is shown in Figure 3, in which the input transistors Tᵢₙ₁ and Tᵢₙ₂ both couple a dc voltage "V_{high}" to the respective capacitor. An additional reset transistor is shown in the input section 10. The coupling of a high dc voltage is more easily achieved with bottom gate transistor technology. This design reduces the load on the previous row, as the charging currents are drawn from the dc supply. This gives improved circuit performance.

A further benefit of the circuit of Figure 3 is that the circuit can be controlled to provide an idle mode of operation. In an idle state, the circuit presents a high impedance to the row, so that the row pulses can be controlled by a different row driver circuit connected to the other end of the row conductor. It is known to provide two row driver circuits on opposite sides of a display, for example to provide two different modes of operation (different powers, or driving in different directions to allow the display to be used either way up), and an idle mode is required in this case.

The idle mode can be applied to the circuit of Figure 3 by changing V_{high} to V_{off}, and applying the Pn and inverse pulses.

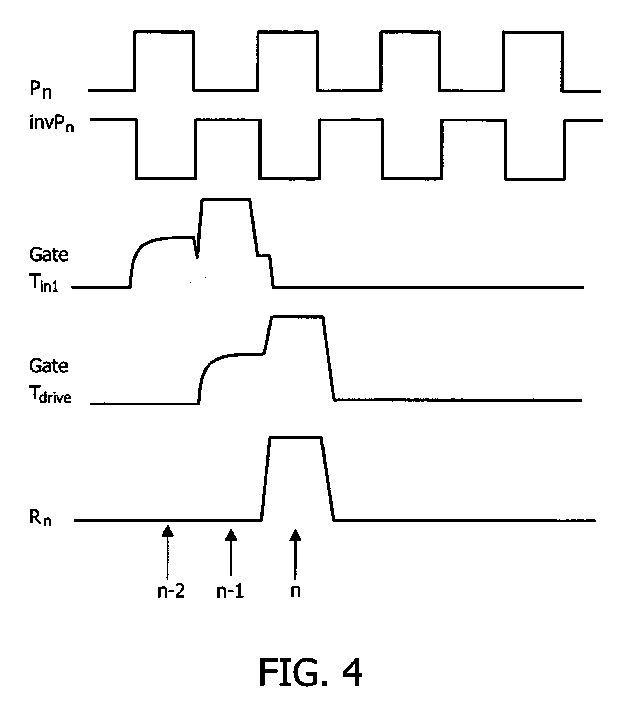

Figure 4 is used to explain schematically the timing principles of operation of the circuit of Figure 2, and the same general principles apply to Figure 3. The plots show the clocked power supply lines, the gate voltage on the first input transistor Tᵢₙ₁, the gate voltage on the drive transistor T_{drive} and the output Rₙ.

During the timing n-2 of the stage two behind, the second bootstrap capacitor C₃ is precharged. At the end of this phase, there is a drop in voltage until the capacitor stores the threshold voltage. This decay of the voltage on the second bootstrap capacitor continues during the application of the output pulse n-1 to the input transistor, and by the end of the output pulse for row n-1, the voltage across the second bootstrap capacitor will have decayed to the threshold voltage, so that threshold compensation is effective for the input transistor, and the full row voltage is used to charge the first bootstrap capacitor.

During the stage n-1, the output of the stage n-1 is capacitively added to the voltage on the second bootstrap capacitor to derive the gate voltage which drives the first input transistor Tᵢₙ₁.

During stage n-1, the first bootstrap capacitor C₂ is also charged, as can be seen from the plot for the drive transistor gate.

During stage n, the clocked power supply line voltage Pₙ is added to the voltage on the first bootstrap capacitor C₂ to derive the gate voltage of the drive transistor T_{drive}.

The beginning of cycle n is used to discharge the second bootstrap capacitor C₃ through the reset transistor Tᵣ₍ₙ₎ controlled by Rₙ.

The circuit of the invention is particularly suitable for use in the row driver circuit of an active matrix liquid crystal display.

The circuit shown in Figure 2 uses an extra input stage to correct for the threshold voltage of the input TFT (Tᵢₙ).

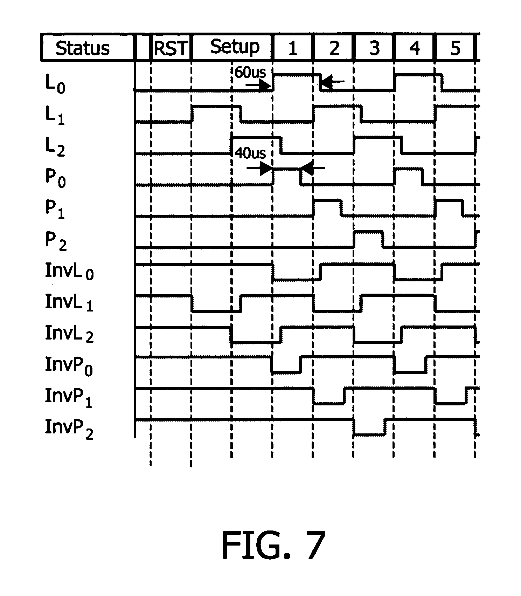

The timing diagram of Figure 4 uses two phase clocking. In practice, the implementation of the circuit of Figure 3 will use three phase clocking. In other words, the values of Pₙ₋₂ and Pₙ are no longer the same. An example of three phase clocking is shown in Figure 7, described below. The use of a dc voltage in Figure 3 requires the three phase control signals to prevent C3 and C2 both charging during the Rₙ₋₂ row pulse.

An alternative approach is to adapt the input stage so that it is not limited to raising the effective gate drive voltage of Tᵢₙ by its threshold voltage, but can raise the drive voltage by a much larger amount. This further improves the charging of the circuit capacitance nodes, and so improves operation.

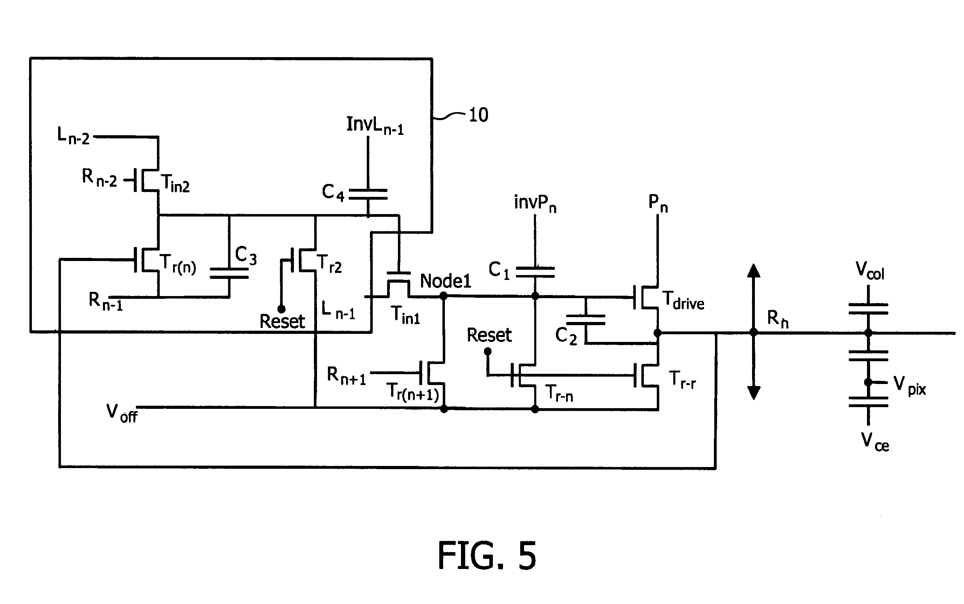

Figure 5 shows one stage of a shift register circuit in accordance with this second embodiment of the invention.

The circuit is the same as the circuit of Figure 2, apart from the input section 10, and a description of the repeated circuit components will not be given.

The input section 10 again has a second input transistor Tᵢₙ₂ which supplies a signal with timing based on the output of the stage two stages before the stage to the gate of the first input transistor Tᵢₙ₁. In the circuit of Figure 4, the output Rₙ₋₂ two stages before controls the timing, but a different voltage waveform is applied to the drain of the second input transistor Tᵢₙ₂, and this is shown as Lₙ₋₂. This will be called a second input line.

Similarly, the first input transistor Tᵢₙ₁ is connected between a first input line Lₙ₋₁ and the gate of the drive transistor T_{drive}. The input line Lₙ₋₁ is high when the output of the stage before is high, so that the operation is similar to Figure 2. However, for reasons explained below, the input Lₙ₋₁ is also high immediately after the output of the stage before has had a transition from high to low.

The first and second input lines may be clocked signals, but they can be delayed versions of each other, so that there is effectively only one additional clocked signal for each phase of the input clocks Pn. Alternatively, dc voltages may be used.

As in the circuit of Figure 2, the second bootstrap capacitor C₃ is connected between the output Rₙ₋₁ of the previous stage and the gate of the first input transistor Tᵢₙ₁, and this second bootstrap capacitor is charged with timing based on the output of the stage two stages before. However, there is no decay transistor, so that the charge on the second bootstrap capacitor is not limited to a threshold voltage, but can instead be selected based on the voltage of the input Lₙ₋₂ minus the threshold voltage of Tᵢₙ₂.

An (optional) input section reset transistor Tᵣ₂ is connected between the gate of the first input transistor Tᵢₙ₁ and the low power line V_{off}, and this is for reset of the driver.

The gate of the first input transistor Tᵢₙ₁ may be connected to a clocked signal which is the inverse of the first input line Lₙ₋₁ through a capacitor C₄, and this is to prevent the rising edge of Lₙ₋₁ coupling through the parasitic gate-drain capacitance of Tᵢₙ₁ and turning it on. The capacitor C₄ couples in a complementary signal that cancels this effect out, and the value of C₄ is accordingly chosen to be proportional to the capacitance of Tᵢₙ₁ with the same proportionality as between C₁ and the drive transistor.

In the embodiment of Figure 5, the input section feedback reset transistor Tᵣ₍ₙ₎ is connected between the gate of the first input transistor Tᵢₙ₁ and the output of the preceding stage Rₙ₋₁, and again has its gate connected to the output of the stage, for discharging the second bootstrap capacitor C₃.

In operation of the circuit of Figure 5, the high pulse of the output of the stage two stages behind Rₙ₋₂ again charges the second bootstrap capacitor C₃ through the second input transistor Tᵢₙ₂. The second input line Lₙ₋₂ is high during this time. There is no decay transistor to limit the charging. Thus, instead of charging C₃ to a threshold voltage, it may charge to the voltage of the second input line, less the threshold voltage of the second input transistor. This second input line will typically carry the row voltage, but the timing is not the same, as explained below.

When the preceding stage output Rₙ₋₁ pulses high, and the first input line Lₙ₋₁ is also high, the gate of the first input transistor Tᵢₙ₁ is bootstrapped by the second bootstrap capacitor C₃, resulting in very good charging of the gate of the drive transistor T_{drive}.

When the output Rₙ₋₁ goes low, the charge is not removed from the first bootstrap capacitor C₂ via Tᵢₙ₁ as Lₙ₋₁ is arranged to remain high until after C₃ is discharged. This is the reason why different timing is needed for the first input Lₙ₋₁ than the timing of the output Rₙ₋₁, even though the voltage levels can be the same. As soon as row N goes high, the feedback reset transistor Tᵣ₍ₙ₎ discharges the voltage across C₃, turning Tᵢₙ₁ completely off, in the same way as for the embodiment of Figure 2.

The circuit operation proceeds in the same way as explained above.

The circuit of Figure 5 has the same number of TFTs as in Figure 2, but some extra clock lines are required. However, the bootstrapping of the first input transistor Tᵢₙ₁ is far better.

If the TFT technology has sufficiently good switching characteristics, a DC voltage equivalent to the row high voltage may replace the clocked signals Lₙ.

In this case, the capacitor C₄ and the inverted clocks Lₙ are not required, and circuit performance is improved even further.

The circuit of Figure 5 has the same further benefits mentioned above that the internal capacitance nodes draw their charging current from the clock lines Ln, rather than the previous rows. This decreases the load which needs to driven by each output TFT.

This circuit also has the benefit that by applying appropriate signals, the row driver may remain in the idle state, while another row driver drives the display with a differing pulse sequence. As mentioned above, this can be used, for example, to provide a display that can scan in forwards or reverse directions.

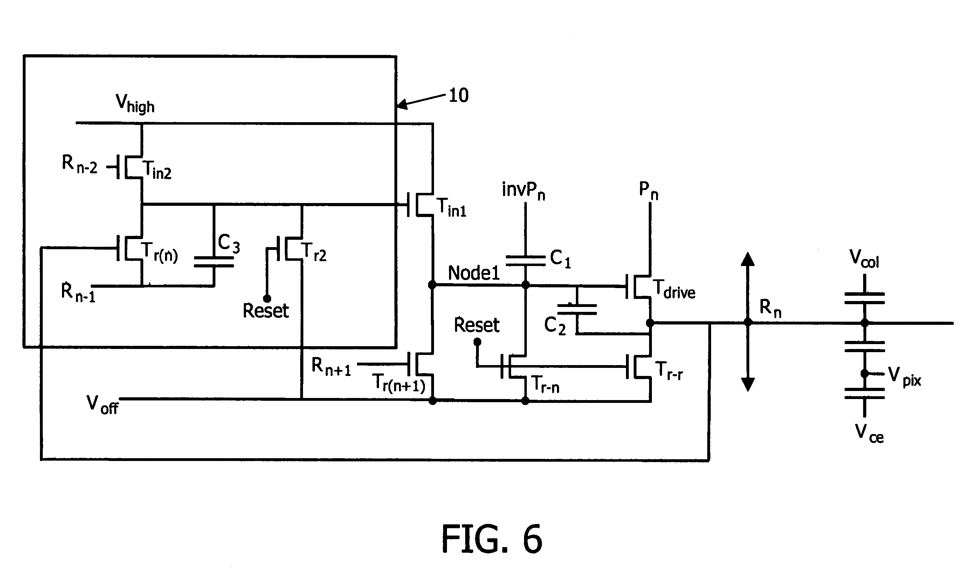

Figure 6 shows a modification to the circuit of Figure 5, in which dc voltages are again used in place of the timing signals Ln, and this is again most appropriate for bottom gate technology. This reduces the clock count and avoids the need for the capacitance C₄. The circuit can be idled in the same way as explained with reference to Figure 3.

Figure 7 shows a clock timing diagram for the circuit of Figure 5, and shows signals for the input lines L for three successive rows as well as signals for the power lines for the three successive rows.

As shown, the pulses on the input lines L have a duration longer than the row address period, and this duration is shown by way of example as 60µs. The clocked power line pulses are shorter, shown by way of example as 40µs.

The signals shown in the timing diagram have repeating pulses, so that only three different power P and input line L waveforms and their complements are needed to address the full array.

It will be apparent that each stage of the shift register circuit requires two timing pulses for correct operation; one from the preceding row and one from the row two behind. For the first shift register circuit stage, two externally generated timing signals are therefore required to initiate the correct operation of the shift register circuit. This is a possible disadvantage of the circuit compared to the simpler circuit of Figure 1, which requires only one start pulse for the first shift register stage, to replicate the signal Rₙ₋₁.

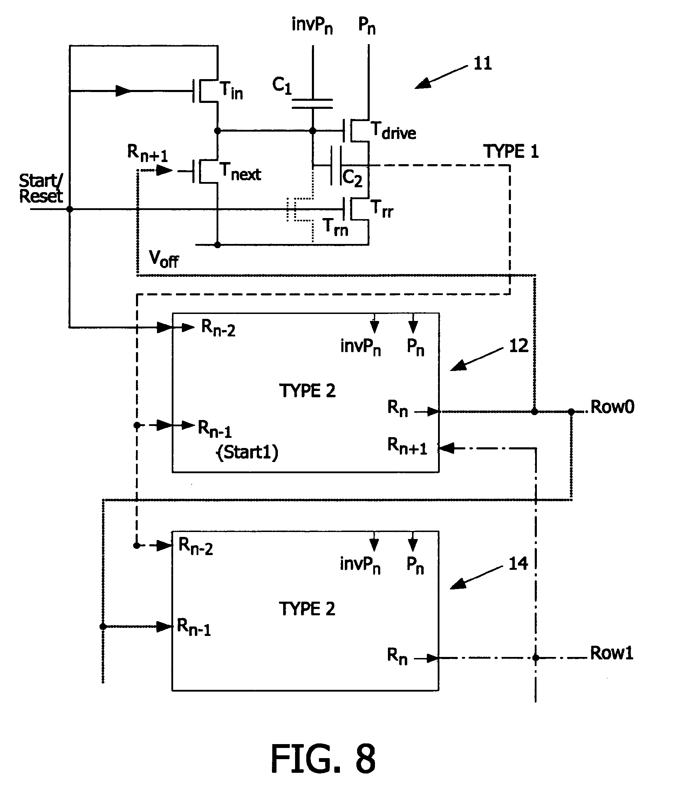

Figure 8 shows a way of structuring the shift register circuit so that only one start pulse is required.

The shift register has a first initiation circuit 11 which requires a single start signal and which emulates the output from the preceding stage. The circuit also uses the clocked power line signals Pn and invPn. This circuit generates an output signal, so that the single start signal and the output signal (which is generated internally by the circuit) can provide the two previous signals required for the timing of the next stage.

This first stage can be considered to be a "Type 1" shift register circuit, which has dependency only on one preceding stage. As can be seen from Figure 8, the circuit 11 can comprise the known shift register stage of Figure 1. However, the circuit 11 may be designed simply to provide an output which is a suitably delayed version of the start/reset pulse, and may therefore comprise a simpler circuit to implement a delay function.

The start/reset signal is an external timing signal, and it can therefore have a clean waveform. As the pulses propagate through the shift register stages, the pulse quality degrades. However, as the Type 1 circuit is at the top of the shift register chain, it can be used as the shift register stage for the first row. Thus, the circuit 11 may comprise a first shift register stage for driving the first row of pixels, or else it may simply be provided to convert a single start pulse into two timing pulses, which are then used for the first stage of the shift register circuit. This essentially comprises a delay function as explained above, with the delay corresponding to the time between outputs of the subsequent shift register stages.

The example of Figure 8 uses the circuit 11 simply for timing, and the next stage is shown as driving "Row 0".

As shown, the next stages can be considered to be "Type 2" circuits, and these are circuits in accordance with the invention, including any of the variations and alternatives. Thus, each shift register stage 12,14 comprises a circuit as described with reference to Figures 2 to 7.

The stage 12 for the first row receives as the Rₙ₋₂ input the start/reset pulse, and as the Rₙ₋₁ input the output of the circuit 11. The circuit 12 also feeds back its output to the circuit 11 as the Rₙ₊₁ input for the circuit 11.

The remaining shift register circuit stages are then connected in sequence.

With appropriate selection of the circuit design of the shift register stages, the complete circuit can thus be implemented with a two phase clock signal and a single start pulse.

The circuits above require good matching of the capacitance of the compensation capacitor C₁ (for compensating for the effects of the parasitic capacitance of the drive transistor) and the capacitance of the drain of the drive transistor. The drive transistor will made with the finest definition process, to save space and power. This can lead to variations in the parasitic capacitances due to line width variations. Thus, good matching with the capacitor C₁ is difficult to achieve, which can in turn restrict the operational range of the circuit.

This problem can be addressed by making the amplitude of the inverted clock signal invPn separately adjustable to the amplitude of the non-inverted clock signal Pn. The inverted signal can then be selected to suit the dimensions of the drive transistor with particular process variations, after the device manufacture. This has the same electrical effect as changing the size of the capacitor but does not require change to the physical capacitor design. This adjustment can be made after manufacture, and can therefore be used to compensate for unexpected or unpredictable process variations, such as line width.

The non-inverted clock is used to form the output of the stage whereas the inverted clock input is used for the compensation signal, and this enables the two signals to be treated independently, without changes to one signal adversely affecting the response of the circuit to the other signal.

The variable inverse clock amplitude can also be used to compensate for ambient conditions. For example, it can be increased at high temperatures to extend the upper temperature limit of the circuit operation, and it can be reduced at low temperatures to extend the lower temperature limit of the circuit operation.

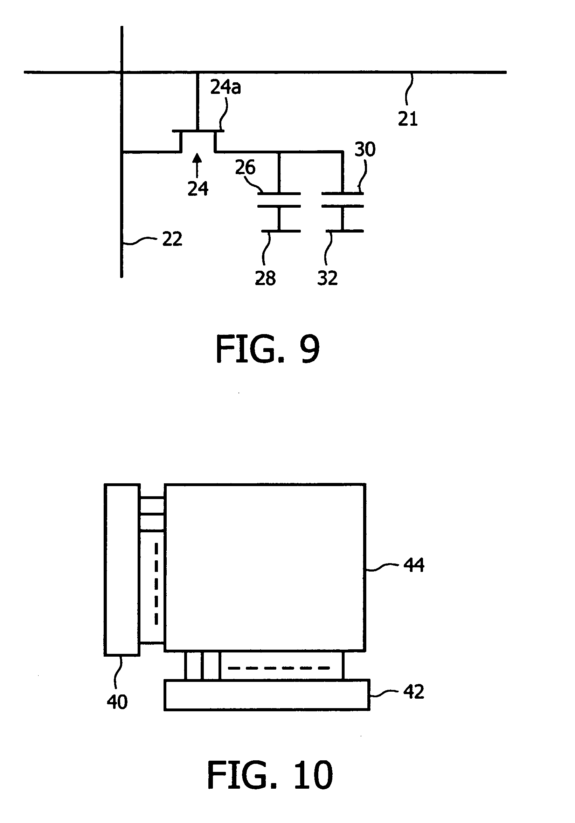

Figure 9 shows a conventional pixel configuration for an active matrix liquid crystal display. The display is arranged as an array of pixels in rows and columns. Each row of pixels shares a common row conductor 21, and each column of pixels shares a common column conductor 22. Each pixel comprises a thin film transistor 24 and a liquid crystal cell 26 arranged in series between the column conductor 22 and a common electrode 28. The transistor 24 is switched on and off by the signals provided on the row conductors 21, as described above. Each pixel additionally comprises a storage capacitor 30 which is connected at one end 32 to the next row electrode, to the preceding row electrode, or to a separate capacitor electrode. This capacitor 30 stores a drive voltage so that a signal is maintained across the liquid crystal cell 26 after the transistor 24 has been turned off.

In order to drive the liquid crystal cell 26 to a desired voltage to obtain a required gray level, an appropriate signal is provided on the column conductor 22 in synchronism with the row address pulse on the row conductor 21. This row address pulse turns on the thin film transistor 24, thereby allowing the column conductor 22 to charge the liquid crystal cell 26 to the desired voltage, and also to charge the storage capacitor 30 to the same voltage. At the end of the row address pulse, the transistor 24 is turned off, and the storage capacitor 30 maintains a voltage across the cell 26 when other rows are being addressed. The storage capacitor 30 reduces the effect of liquid crystal leakage and reduces the percentage variation in the pixel capacitance caused by the voltage dependency of the liquid crystal cell capacitance.

The rows are addressed sequentially so that all rows are addressed in one frame period, and refreshed in subsequent frame periods.

As shown in Figure 10, the row address signals are provided by row driver circuitry 40, and the pixel drive signals are provided by column address circuitry 42, to the array 44 of display pixels. The circuit of the invention is suitable for use in the row driver circuitry, and manufactured using amorphous silicon technology. The circuit elements can then be integrated onto the active matrix display substrate.

The circuit of the invention results in far better operation at low temperatures and a wider process margin. This can then be used to allow smaller components to be used for a given application, resulting in lower power and a smaller circuit design, despite the extra TFTs involved (which are all small).

In the example above, the reset transistor Tᵣ₍ₙ₊₁₎ controlled by the next stage is connected between the gate of the drive transistor and the low power line. It may instead be connected between the gate of the drive transistor and the row output, namely across the first bootstrap capacitor C₂. Furthermore, this reset transistor could be connected to the output of a different output stage, for example stage n+2, n+3 etc (up to n + number of clock phases - 1).

As will be apparent from the two examples above, the reset transistor Tᵣ₍ₙ₎ of the input section can be connected between the gate of the first input transistor Tᵢₙ₁ and the low power line V_{off} or between the gate of the first input transistor Tᵢₙ₁ and the preceding row output n-1, namely across the second bootstrap capacitor C₃. These two possibilities are possible for both examples shown. The gate of this reset transistor could also be connected to the output of a different output stage, for example stage n+1, n+2 etc. The circuits can also function without the reset transistor at all.

In the example of Figure 5, the second input transistor Tᵢₙ₂ can be diode-connected as in the example of Figure 2, thereby removing the connection to Lₙ₋₂. Thus, the embodiment of Figure 5 does not need connection to the second input line Lₙ₋₂. The connection to Lₙ₋₂ provides the ability of the circuit to remain in an idle state, while the display is driven differently, as mentioned above.

The detailed examples above use the output from two stages behind as a control signal. However, the double-precharge effect can be achieved using an output from a stage further back. For example, instead of using Rn-1 and Rn-2 as in the examples above, the circuit may be designed to use Rn-2 and Rn-4. This may be desirable if the gate driver is split into odd and even halves, each on different sides of the array. This example also shows that the gate charging controlled by the output of the preceding stage in the examples shown, can in fact also be controlled by a stage further back.

As mentioned above, the invention is particularly suitable for implementation using amorphous silicon transistors, and for this reason, the circuits shown use n-type transistors. However, the invention is also applicable to other circuit technologies, for example organic thin film transistors (which are frequently implemented as p-type devices) or low temperature polysilicon (which may be implemented as PMOS devices). The circuits of the invention can implemented using p-type transistors without modification to the operating principles, and this will be well understood by those skilled in the art. The invention is not intended to be limited to any particular technology type.

It will therefore be apparent that there are numerous variations to the specific circuit described in detail, and many other modifications will be apparent to those skilled in the art.

## Claims

1. A shift register circuit comprising a plurality of stages, each stage comprising:
a first input (Rₙ₋₁) connected to the output of a preceding stage;
a drive transistor (T_{drive}) for coupling a first clocked power line voltage (Pₙ) to the output (Rₙ) of the stage;
a compensation capacitor (C₁) for compensating for the effects of a parasitic capacitance of the drive transistor;
a first bootstrap capacitor (C₂) connected between the gate of the drive transistor and the output (Rₙ) of the stage; and
an input transistor (Tᵢₙ₁) for charging the first bootstrap capacitor (C₂) and controlled by the first input (Rₙ₋₁),
**characterized in that** each stage further comprises an input section (10) coupled to the output (Rₙ₋₂) of the stage two or more stages before the stage, and wherein the input section comprises a second bootstrap capacitor (C₃) connected between the gate of the input transistor (Tᵢₙ₁) and the first input (Rₙ₋₁).

2. A circuit as claimed in claim 1, wherein the input section is coupled to the output (Rₙ₋₂) of the stage two stages before the stage.

3. A circuit as claimed in claim 1 or 2, wherein each stage further comprises a second input (Rₙ₊₁) connected to the output of the next stage.

4. A circuit as claimed in claim 3, wherein the second input (Rₙ₊₁) is connected to the gate of a reset transistor (Tᵣ₍ₙ₊₁₎) which is connected between the gate of the drive transistor and a low power line (V_{off}).

5. A circuit as claimed in any preceding claim, wherein the compensation capacitor (C₁) of each stage is connected between the gate of the drive transistor and a second clocked power line voltage (invPₙ) which is clocked complementarily with the first power line voltage (Pₙ).

6. A circuit as claimed in any preceding claim, wherein the input section (10) comprises circuit elements for storing a transistor threshold voltage on the second bootstrap capacitor (C₃).

7. A circuit as claimed in any preceding claim, wherein the input section further comprises:
a second input transistor (Tᵢₙ₂) which supplies the output of the stage two stages before the stage to the gate of the first input transistor (Tᵢₙ₁); and
a decay transistor (T_{decay}) connected in parallel with the second bootstrap capacitor for decaying the voltage on the second bootstrap capacitor until the threshold voltage of the decay transistor is reached.

8. A circuit as claimed in claim 7, wherein the decay transistor (T_{decay}) has substantially the same dimensions as the first input transistor (Tᵢₙ₁).

9. A circuit as claimed in any one of claims 1 to 5, wherein the input section (10) further comprises a second input transistor (Tᵢₙ₂) which supplies the output of the stage two stages before the stage to the gate of the first input transistor (Tᵢₙ₁).

10. A circuit as claimed in claim 9, wherein the first input transistor (Tᵢₙ₁) is connected between an input line (Lₙ₋₁) and the gate of the drive transistor (T_{drive}), and wherein the input line (Lₙ₋₁) is high when output of the stage before is high, and is high at least immediately after the output of the stage before has a transition from high to low.

11. A circuit as claimed in claim 10, wherein the input line is permanently high during operation of the circuit.

12. A circuit as claimed in claim 10 or 11, wherein the input section further comprises an input section reset transistor (Tᵣ₂) which is connected between the gate of the first input transistor (Tᵢₙ₁) and a low power line (V_{off}).

13. A circuit as claimed in any preceding claim, wherein the input section further comprises a feedback reset transistor (Tᵣ₍ₙ₎) having its gate connected to the output of the stage, for discharging the second bootstrap capacitor (C₃).

14. A circuit as claimed in any preceding claim, wherein an initiation circuit (11) is provided, which receives as input a start signal (Start/Reset), and provides as output a delayed version of the start signal, and wherein the first shift register stage (12) receives the output of the initiation circuit (11) as the output of a preceding stage, and receives the start signal (Start/Reset) as the output of the stage two or more stages before the stage.

15. A circuit as claimed in claim 14, wherein the output of the initiation circuit (11) is delayed by the time delay between the shift register stages.

16. A circuit as claimed in claim 14 or 15, wherein the output of the initiation circuit is used as the first output of the shift register circuit.

17. A circuit as claimed in any preceding claim, implemented using amorphous silicon technology.

18. An active matrix display device, comprising:
an array of active matrix display pixels;
row driver circuitry comprising a shift register circuit as claimed in any preceding claim.

19. An active matrix display device as claimed in claim 18, comprising an active matrix liquid crystal display device.

20. A method of generating multiple stage shift register circuit outputs, comprising, for each stage of the shift register circuit:
using the output of the stage one or more stage before the stage to charge the gate of a drive transistor (T_{drive}) through the input transistor (Tᵢₙ₁) and to charge a first bootstrap capacitor (C₂) storing the gate-source voltage of the drive transistor; and coupling a first clocked power supply line voltage (Pₙ) to the output of the stage through the drive transistor
**characterized in that** it further comprises the step of using the output (Rₙ₋₂) of the stage two or more stages before the stage to charge the gate of an input transistor (Tᵢₙ₁), and storing the gate-source voltage on a second bootstrap capacitor (C₃);

21. A method as claimed in claim 17, further comprising, after storing a gate-source voltage on the second bootstrap capacitor (C₃), discharging the second bootstrap capacitor (C₃) until a threshold voltage is stored on the second bootstrap capacitor.

22. A method as claimed in claim 20 or 21, further comprising coupling a second clocked power supply line voltage (invPₙ) to the drive transistor gate through a compensation capacitor (C₁), the first and second clocked power supply line voltages being clocked complementarily.

23. A method as claimed in claim 20, 21 or 22, further comprising resetting the first bootstrap capacitor (C₂) using the output (Rₙ₊₁) of the next stage.

24. A method as claimed in any one of claims 20 to 23, further comprising resetting the second bootstrap capacitor (C₃) using the output (Rₙ) of the stage.

25. A method as claimed in any one of claims 20 to 24, wherein the output (Rₙ₋₂) of the stage two stages before the stage is used to charge the gate of the input transistor (Tᵢₙ₁) and the output of the stage one stage before the stage is used to charge the gate of the drive transistor (T_{drive}).

## Patentansprüche

1. Schieberegisterschaltung mit mehreren Stufen, wobei jede Stufe umfasst:
- einen ersten Eingang (Rₙ₋₁), der mit dem Ausgang einer vorhergehenden Stufe verbunden ist;
- einen Treibertransistor (T_{drive}) zur Ankopplung einer ersten getakteten Netzspannung (Pₙ) an den Ausgang (Rₙ) der Stufe;
- einen Kompensationskondensator (C₁) zum Ausgleich der Einflüsse einer parasitären Kapazität des Treibertransistors;
- einen ersten Bootstrap-Kondensator (C₂), der zwischen dem Gate des Treibertransistors und dem Ausgang (Rₙ) der Stufe geschaltet ist; sowie
- einen von dem ersten Eingang (Rₙ₋₁) gesteuerten Eingangstransistor (Tᵢₙ₁) zum Laden des ersten Bootstrap-Kondensators (C₂),
**dadurch gekennzeichnet, dass** jede Stufe weiterhin einen Eingangsteil (10) aufweist, der an den Ausgang (Rₙ₋₂) der zwei oder mehr Stufen vor der Stufe liegenden Stufe gekoppelt ist, und wobei der Eingangsteil einen zweiten Bootstrap-Kondensator (C₃) aufweist, der zwischen dem Gate des Eingangstransistors (Tᵢₙ₁) und dem ersten Eingang (Rₙ₋₁) geschaltet ist.

2. Schaltung nach Anspruch 1, wobei der Eingangsteil an den Ausgang (Rₙ₋₂) der zwei Stufen vor der Stufe liegenden Stufe gekoppelt ist.

3. Schaltung nach Anspruch 1 oder 2, wobei jede Stufe weiterhin einen zweiten Eingang (Rₙ₊₁) aufweist, der mit dem Ausgang der nächsten Stufe verbunden ist.

4. Schaltung nach Anspruch 3, wobei der zweite Eingang (Rₙ₊₁) mit dem Gate eines Rücksetztransistors (Tᵣ₍ₙ₊₁₎) verbunden ist, welcher zwischen dem Gate des Treibertransistors und einer Schwachstromleitung (V_{off}) geschaltet ist.

5. Schaltung nach einem der vorangegangenen Ansprüche, wobei der Kompensationskondensator (C₁) jeder Stufe zwischen dem Gate des Treibertransistors und einer zweiten getakteten Netzspannung (invPₙ), die komplementär zu der ersten Netzspannung (Pₙ) getaktet wird, geschaltet ist.

6. Schaltung nach einem der vorangegangenen Ansprüche, wobei der Eingangsteil (10) Schaltungselemente aufweist, um eine Transistor-Schwellenspannung auf dem zweiten Bootstrap-Kondensator (C₃) zu speichern.

7. Schaltung nach einem der vorangegangenen Ansprüche, wobei der Eingangsteil weiterhin aufweist:
- einen zweiten Eingangstransistor (Tᵢₙ₂), welcher dem Gate des ersten Eingangstransistors (Tᵢₙ₁) das Ausgangssignal der zwei Stufen vor der Stufe liegenden Stufe zuführt; sowie
- einen Abschwelltransistor (T_{decay}), der parallel zu dem zweiten Bootstrap-Kondensator geschaltet ist, um die Spannung an dem zweiten Bootstrap-Kondensator herabzusetzen, bis die Schwellenspannung des Abschwelltransistors erreicht ist.

8. Schaltung nach Anspruch 7, wobei der Abschwelltransistor (T_{decay}) im Wesentlichen die gleichen Dimensionen wie der erste Eingangstransistor (Tᵢₙ₁) aufweist.

9. Schaltung nach einem der Ansprüche 1 bis 5, wobei der Eingangsteil (10) weiterhin einen zweiten Eingangstransistor (Tᵢₙ₂) umfasst, welcher dem Gate des ersten Eingangstransistors (Tᵢₙ₁) das Ausgangssignal der zwei Stufen vor der Stufe liegenden Stufe zuführt.

10. Schaltung nach Anspruch 9, wobei der erste Eingangstransistor (Tᵢₙ₁) zwischen einer Eingangsleitung (Lₙ₋₁) und dem Gate des Treibertransistors (T_{drive}) geschaltet ist, und wobei die Eingangsleitung (Lₙ₋₁) auf High-Pegel ist, wenn das Ausgangssignal der vorherigen Stufe High ist, und, zumindest unmittelbar nachdem das Ausgangssignal der vorherigen Stufe einen Übergang von High nach Low aufweist, auf High-Pegel ist.

11. Schaltung nach Anspruch 10, wobei die Eingangsleitung während des Betriebs der Schaltung permanent auf High-Pegel ist.

12. Schaltung nach Anspruch 10 oder 11, wobei der Eingangsteil weiterhin einen Eingangsteil-Rücksetztransistor (Tᵣ₂) aufweist, der zwischen dem Gate des ersten Eingangstransistors (Tᵢₙ₁) und einer Schwachstromleitung (V_{off}) geschaltet ist.

13. Schaltung nach einem der vorangegangenen Ansprüche, wobei der Eingangsteil weiterhin einen Rückkopplungs-Rücksetztransistor (Tᵣ₍ₙ₎) aufweist, dessen Gate mit dem Ausgang der Stufe verbunden ist, um den zweiten Bootstrap-Kondensator (C₃) zu entladen.

14. Schaltung nach einem der vorangegangenen Ansprüche, wobei eine Auslöseschaltung (11) vorgesehen ist, welche als Eingangssignal ein Startsignal (Start/Reset) empfängt und als Ausgangssignal eine verzögerte Version des Startsignals vorsieht, und wobei die erste Schieberegisterstufe (12) das Ausgangssignal der Auslöseschaltung (11) als Ausgangssignal einer vorhergehenden Stufe und das Startsignal (Start/Reset) als Ausgangssignal der zwei oder mehr Stufen vor der Stufe liegenden Stufe empfängt.

15. Schaltung nach Anspruch 14, wobei das Ausgangssignal der Auslöseschaltung (11) um die Zeitverzögerung zwischen den Schieberegisterstufen verzögert wird.

16. Schaltung nach Anspruch 14 oder 15, wobei das Ausgangssignal der Auslöseschaltung als das erste Ausgangssignal der Schieberegisterschaltung verwendet wird.

17. Schaltung nach einem der vorangegangenen Ansprüche, welche unter Anwendung einer Technologie auf der Basis von amorphem Silicium realisiert wird.

18. Aktivmatrix-Anzeigeeinrichtung mit:
- einem Array von Aktivmatrix-Anzeigepixeln,
- einer Zeilenansteuerungsschaltung mit einer Schieberegisterschaltung nach einem der vorangegangenen Ansprüche.

19. Aktivmatrix-Anzeigeeinrichtung nach Anspruch 18 mit einer Aktivmatrix-Flüssigkristallanzeigeeinrichtung.

20. Verfahren zur Erzeugung von Mehrfachstufen-Schieberegister-Ausgangssignalen, welches für jede Stufe der Schieberegisterschaltung die folgenden Schritte umfasst:
- Verwendung des Ausgangssignals der eine oder mehrere Stufen vor der Stufe liegenden Stufe zum Laden des Gates eines Treibertransistors (T_{drive}) durch den Eingangstransistor (Tᵢₙ₁) und zum Laden eines die Gate-Source-Spannung des Treibertransistors speichernden, ersten Bootstrap-Kondensator (C₂), sowie
- Ankopplung einer ersten getakteten Netzspannung (Pₙ) an den Ausgang der Stufe durch den Treibertransistor,
**dadurch gekennzeichnet, dass** das Verfahren weiterhin die folgenden Schritte umfasst:
- Verwendung des Ausgangssignals (Rₙ₋₂) der zwei oder mehrere Stufen vor der Stufe liegenden Stufe zum Laden des Gates eines Eingangstransistors (Tᵢₙ₁) und Speicherung der Gate-Source-Spannung auf einem zweiten Bootstrap-Kondensaotr (C₃).

21. Verfahren nach Anspruch 17, welches nach Speicherung einer Gate-Source-Spannung auf dem zweiten Bootstrap-Kondensator (C₃) weiterhin das Entladen des zweiten Bootstrap-Kondensators (C₃) umfasst, bis eine Schwellenspannung auf dem zweiten Bootstrap-Kondensator gespeichert wird.

22. Verfahren nach Anspruch 20 oder 21, welches weiterhin die Ankopplung einer zweiten getakteten Netzspannung (invPₙ) an das Gate des Treibertransistors durch einen Kompensationskondensator (C₁) umfasst, wobei die erste und zweite getaktete Netzspannung komplementär getaktet werden.

23. Verfahren nach Anspruch 20, 21 oder 22, welches weiterhin das Rücksetzen des ersten Bootstrap-Kondensators (C₂) unter Verwendung des Ausgangssignals (Rₙ₊₁) der nächsten Stufe umfasst.

24. Verfahren nach einem der Ansprüche 20 bis 23, welches weiterhin das Rücksetzen des zweiten Bootstrap-Kondensators (C₃) unter Verwendung des Ausgangssignals (Rₙ) der Stufe umfasst.

25. Verfahren nach einem der Ansprüche 20 bis 24, wobei das Ausgangssignal (Rₙ₋₂) der zwei Stufen vor der Stufe liegenden Stufe zum Laden des Gates des Eingangstransistors (Tᵢₙ₁) und das Ausgangssignal der eine Stufe vor der Stufe liegenden Stufe zum Laden des Gates des Treibertransistors (T_{drive}) eingesetzt werden.

## Revendications

1. Circuit de registre à décalage comprenant une pluralité d'étages, chaque étage comprenant:
une première entrée (Rₙ₋₁) qui est connectée à la sortie d'un étage précédent;
un transistor amplificateur (T_{drive}) pour coupler une première tension synchronisée de ligne électrique (Pₙ) à la sortie (Rₙ) de l'étage;
un condensateur de compensation (C₁) pour compenser les effets d'une capacité parasite du transistor amplificateur;
un premier condensateur de circuit fermé (C₂) qui est connecté entre la grille du transistor amplificateur et la sortie (Rₙ) de l'étage; et
un transistor d'entrée (Tᵢₙ₁) pour charger le premier condensateur de circuit fermé (C₂) et qui est commandé par la première entrée (Rₙ₋₁),
**caractérisé en ce que** chaque étage comprend encore une section d'entrée (10) qui est couplée à la sortie (Rₙ₋₂) de l'étage deux ou plusieurs étages avant l'étage et dans lequel la section d'entrée comprend un deuxième condensateur de circuit fermé (C₃) qui est connecté entre la grille du transistor d'entrée (Tᵢₙ₁) et la première entrée (Rₙ₋₁).

2. Circuit selon la revendication 1, dans lequel la section d'entrée est couplée à la sortie (Rₙ₋₂) de l'étage deux étages avant l'étage.

3. Circuit selon la revendication 1 ou 2, dans lequel chaque étage comprend encore une deuxième entrée (Rₙ₊₁) qui est connectée à la sortie de l'étage suivant.

4. Circuit selon la revendication 3, dans lequel la deuxième entrée (Rₙ₊₁) est connectée à la grille d'un transistor de remise à zéro (Tᵣ₍ₙ₊₁) qui est connecté entre la grille du transistor amplificateur et une basse ligne électrique (V_{off}).

5. Circuit selon l'une quelconque des revendications précédentes 1 à 4, dans lequel le condensateur de compensation (C₁) de chaque étage est connecté entre la grille du transistor amplificateur et une deuxième tension synchronisée de ligne électrique (invPₙ) qui est synchronisée complémentairement de la première tension de ligne électrique (Pₙ).

6. Circuit selon l'une quelconque des revendications précédentes 1 à 5, dans lequel la section d'entrée (10) comprend des éléments de circuit pour stocker une tension de seuil du transistor sur le deuxième condensateur de circuit fermé (C₃).

7. Circuit selon l'une quelconque des revendications précédentes 1 à 6, dans lequel la section d'entrée comprend encore:
un deuxième transistor d'entrée (Tᵢₙ₂) qui fournit la sortie de l'étage deux étages avant l'étage à la grille du premier transistor d'entrée (Tᵢₙ₁); et
un transistor d'affaiblissement (T_{decay}) qui est connecté en parallèle au deuxième condensateur de circuit fermé pour affaiblir la tension sur le deuxième condensateur de circuit fermé jusqu'à ce que la tension de seuil du transistor d'affaiblissement soit atteinte.

8. Circuit selon 1 revendication 7, dans lequel le transistor d'affaiblissement (T_{decay}) présente sensiblement les mêmes dimensions que le premier transistor d'entrée (Tᵢₙ₁).

9. Circuit selon l'une quelconque des revendications précédentes 1 à 5, dans lequel la section d'entrée (10) comprend encore un deuxième transistor d'entrée (Tᵢₙ₂) qui fournit la sortie de l'étage deux étages avant l'étage à la grille du premier transistor d'entrée (Tᵢₙ₁).

10. Circuit selon la revendication 9, dans lequel le premier transistor d'entrée (Tᵢₙ₁) est connecté entre une ligne d'entrée (Lₙ₋₁) et la grille du transistor amplificateur (T_{drive}), et dans lequel la ligne d'entrée (Lₙ₋₁) est haute lorsque la sortie de l'étage est haute, et est haute au moins immédiatement après que la sortie de l'étage en avant présente une transition de haut en bas.

11. Circuit selon la revendication 10, dans lequel la ligne d'entrée est en permanence haute pendant le fonctionnement du circuit.

12. Circuit selon la revendication 10 ou 11, dans lequel la section d'entrée comprend encore un transistor de remise à zéro (Tᵣ₂) de la section d'entrée qui est connecté entre la grille du premier transistor d'entrée (Tᵢₙ₁) et une basse ligne électrique (V_{off}).

13. Circuit selon l'une quelconque des revendications précédentes 1 à 12, dans lequel la section d'entrée comprend encore un transistor de remise de rétroaction (Tᵣ₍ₙ₎) ayant sa grille connectée à la sortie de l'étage pour décharger le deuxième condensateur de circuit fermé (C₃).

14. Circuit selon l'une quelconque des revendications précédentes 1 à 13, dans lequel il est fourni un circuit de déclenchement (11) qui reçoit en tant qu'entrée un signal de départ (départ/remise à zéro) et qui fournit en tant que sortie une version retardée du signal de départ, et dans lequel le premier étage de registre à décalage (12) reçoit la sortie du circuit de déclenchement (11) en tant que sortie d'un étage précédent, et qui reçoit le signal de départ (départ/remise à zéro) en tant que sortie de l'étage deux ou plusieurs étages avant l'étage.

15. Circuit selon la revendication 14, dans lequel la sortie du circuit de déclenchement (11) est retardée du retard entre les étages de registre à décalage.

16. Circuit selon la revendication 14 ou 15, dans lequel la sortie du circuit de déclenchement est utilisée en tant que première sortie du circuit de registre à décalage.

17. Circuit selon l'une quelconque des revendications 1 à 16, qui est mis en oeuvre à l'aide d'une technologie amorphe de silicium.

18. Dispositif d'affichage à matrice active, comprenant:
un réseau de pixels d'affichage à matrice active;
des circuits d'attaque de rangée comprenant un circuit de registre à décalage selon l'une quelconque des revendications précédentes 1 à 17.

19. Dispositif d'affichage à matrice active selon la revendication 18, comprenant un dispositif d'affichage à cristaux liquides à matrice active.

20. Procédé de génération de sorties du circuit de registre à décalage à étages multiples, comprenant pour chaque étage du circuit de registre à décalage:
l'utilisation de la sortie de l'étage un ou plusieurs étages avant l'étage pour charger la grille d'un transistor amplificateur (T_{drive}) par le biais du transistor d'entrée (Tᵢₙ₁) et pour charger un premier condensateur de circuit fermé (C₂) stockant la tension de grille-source du transistor amplificateur; et
le couplage d'une première tension synchronisée de ligne électrique (Pₙ) à la sortie de l'étage par le biais du transistor amplificateur;
**caractérisé en ce qu'**il comprend encore l'étape suivante consistant à:
utiliser la sortie ((Rₙ₋₂) de l'étage deux ou plusieurs étages avant l'étage pour charger la grille d'un transistor d'entrée (Tᵢₙ₁) et pour stocker la tension de grille-source sur un deuxième condensateur de circuit fermé (C₃).

21. Procédé selon la revendication 17, comprenant encore, après le stockage d'une tension de grille-source sur le deuxième condensateur de circuit fermé (C₃), la décharge du deuxième condensateur de circuit fermé (C₃) jusqu'à ce qu'une tension de seuil soit stockée sur le deuxième condensateur de circuit fermé.

22. Procédé selon la revendication 20 ou 21, comprenant encore le couplage d'une deuxième tension synchronisée de ligne électrique (invPₙ) à la grille du transistor amplificateur par le biais d'un condensateur de compensation (C₁), les première et deuxième tensions synchronisées de ligne électrique étant synchronisées complémentairement.

23. Procédé selon la revendication 20, 21 ou 22, comprenant encore la remise à zéro du premier condensateur de circuit fermé (C₂) à l'aide de la sortie (Rₙ₊₁) de l'étage suivant.

24. Procédé selon l'une quelconque des revendications précédentes 20 à 23, comprenant encore la remise à zéro du deuxième condensateur de circuit fermé (C₃) à l'aide de la sortie (Rₙ) de l'étage.

25. Procédé selon l'une quelconque des revendications précédentes 20 à 24, dans lequel la sortie (Rₙ₋₂) de l'étage deux étages avant l'étage est utilisée pour charger la grille du transistor d'entrée (Tᵢₙ₁) et dans lequel la sortie de l'étage un étage avant l'étage est utilisée pour charger la grille du transistor amplificateur (T_{drive}).
